# EUROPEAN PATENT SPECIFICATION

(11) **EP 1 776 167 B1**
(45) Date of publication and mention of the grant of the patent: **01.12.2010**
(21) Application number: 05772452.8
(22) Date of filing: 08.07.2005
(51) Int. Cl.: A63H 3/00

(54) **A TOY SENSITIVE TO HUMAN TOUCH**
AUF MENSCHLICHE BERÜHRUNG ANSPRECHENDES SPIELZEUG
JOUET SENSIBLE AU CONTACT D'UN ETRE HUMAIN

(30) Priority: 08.07.2004 FR 0407655
(43) Date of publication of application: 25.04.2007
(73) Proprietor: Mattel, Inc., El Segundo, CA 90245 (US)
(72) Inventor: CHAN, Thomas, Tsimshatsui, Kowloon, Hong Kong (CN)
(74) Representative: Bérogin, Francis
(86) International application number: PCT/EP2005/008208
(87) International publication number: WO 2006/005635

(56) References cited:
- US-A1- 2002 081 937
- US-A1- 2004 043 696
- US-B1- 6 238 262
- US-B1- 6 742 188

## Description

The present invention relates to a toy including means for detecting the approach of a portion of a living being, in particular for the purpose of triggering an effect, e.g. a sound effect, a light effect, or even a movement performed by said toy. More particularly, the invention relates to a doll including means for detection by the capacitive effect, combined with other detection systems. The field concerned is that of toys and the electronics in such toys.

It is known to use capacitive effect detectors for actuating effects in a toy such as a doll. The US patent application published under the No. US 2004/0043696 discloses a toy including a capacitive effect contactless detection system having a conductive receiver plate, an effect activation circuit, and means for interconnecting those two elements. The receiver plates can be hidden inside the toy so as to avoid any detection system being visible or apparent on the outside of the toy. When an object comes close to one of the receiver plates, the capacitance measured at that plate is modified. Consequently, by measuring the time constant of an RC circuit, equal to the product RxC where C is the capacitance of the plate and R is a resistance in the circuit, it is possible to detect variations in said time constant while discharging the RC circuit. The RC circuit discharge time is thus measured and then compared with a reference value in order to determine whether the capacitance has changed. Such a variation in the discharge time means that an object is in the proximity of the doll or the toy.

However, if a metal plate is brought up to the toy, the toy detects the presence of the plate and therefore triggers its effects. The toy thus appears to respond even though no portion of a living being is in the proximity of the sensor. Such interference can be caused in this way by any nearby metal object of large weight or area.

An objective of the present invention is to remedy the above-mentioned drawbacks. The invention thus proposes a detection system avoiding that kind of interference. It is based on the fact that the body of a living being transmits radio waves. More precisely, the electrical power distribution network emits radio waves having the same waveform as the electricity it distributes. These waves are picked up by nearby living beings and re-emitted.

The present invention thus provides a toy including at least one capacitive sensor comprising a metal plate constituting one of the two plates of a capacitor, the second plate being constituted by a portion of a living being in the proximity of the toy,
at least one effects generator; and
a control circuit including means for causing effects to take place in response to stimulation of said capacitive sensor;
the toy being **characterized in that** said metal plate of said at least one capacitive sensor is used as an antenna for picking up radio frequency transmission from said portion of a living being in the proximity of the toy.

Advantageously, the radio frequency transmission is at the frequency of an electrical power distribution network.

In the preferred embodiment, the toy of the invention advantageously comprises:
· means for charging and discharging the capacitor of said at least one capacitive sensor;
· a counter for measuring the discharge time of said at least one capacitive sensor;
· means for starting the counter when the capacitor is charged, and means for stopping the counter when the capacitor is discharged;
· a control circuit connected to the counter and having means for storing a plurality of discharge times issued by the counter, said plurality of discharge times constituting a collection, the control circuit comprising means for analyzing the collection of a plurality of discharge times, and means for detecting variation in the mean value of the collection relative to the mean value of the preceding collection, the control circuit also comprising means for comparing variation in the values of the discharge times within a single collection with a sinusoidal signal of frequency substantially equal to the frequency of an electrical power distribution network;
· a resistor which is located between ground and the base of the first plate of the capacitor of said at least one capacitive sensor, the resistor and the capacitor thus constituting an RC circuit; and
· a variable frequency radio frequency generator generating an electromagnetic field, at least one accessory including a passive resonant circuit constituted by an inductor connected in series with a capacitor and responsive to an electromagnetic field at a determined frequency; and means for determining the presence of at least one accessory and for stimulating the effects generator in such a manner as to cause it to produce an effect.

In the preferred embodiment, the invention provides a doll having a plurality of capacitive sensors situated at various locations on the doll.

In another aspect, the invention provides a method of detecting human presence for a toy including a capacitive sensor having a metal plate constituting one of the two plates of a capacitor, the second plate of the capacitor being constituted by a portion of a living being in the proximity of the toy, said method comprising at least the steps consisting in:
· making a collection comprising a plurality of values for the discharge time of the capacitor;
· comparing the mean value of the collection with a reference discharge time value;
· comparing the mean value of the collection with the mean value of the preceding collection; and
· comparing any variations between the discharge time values of the capacitor within the collection with a sinusoidal signal of frequency substantially equal to the frequency of the electrical power distribution network.

Advantageously, this second aspect of the invention comprises the following characteristics:
· it is concluded that a portion of a living being is present when the variations in the discharge time values present substantially the form of said sinusoidal signal;
· it is concluded that a portion of a living being is present if the mean value of the current collection is substantially equal to the mean value of the preceding collection, and if it was previously concluded that a portion of a living being was present;
· it is concluded that no portion of a living being is present when the mean value of the current collection is substantially equal to a reference value;
· the reference value is a function of external conditions; and
· the collection comprises ten discharge time values.

Other features and advantages of the present invention appear from the following description of nonlimiting embodiments, given with reference to the accompanying drawings, in which:
· Figure 1 is a diagram showing a doll in accordance with the invention;
· Figure 2 is a schematic of an electronic circuit associated with a capacitive sensor plate in the Figure 1 doll;
· Figure 3 is a flow chart of the detection method of the invention implemented by the Figure 2 circuit; and
· Figure 4 is a graph plotting variations in discharge time within a collection during a contact.

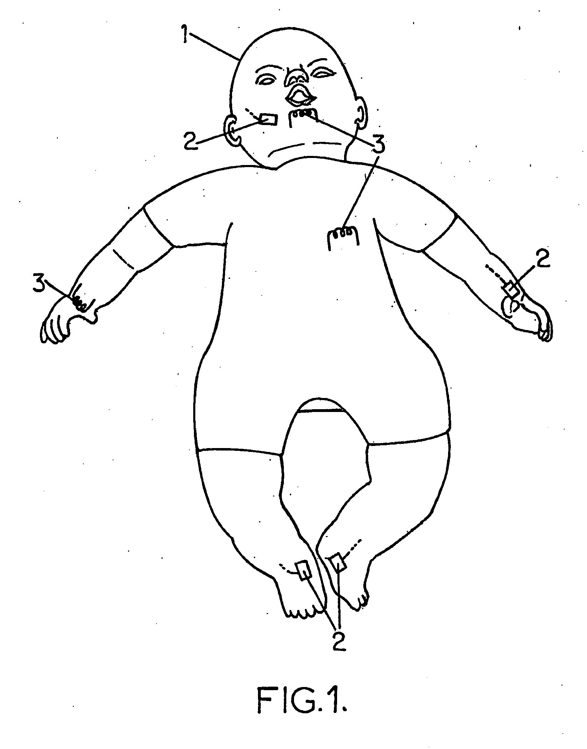

Figure 1 shows the preferred embodiment of the invention. It shows a doll 1 having a plurality of sensors at various locations of its body. These sensors may be of several kinds. Thus, capacitive sensors 2 in accordance with the present invention are situated on the feet, one of the wrists, and one of the cheeks of the doll 1, while inductive sensors 3 are situated on the lips, the chest, and the other wrist of the doll 1. Whereas the inductive sensors 3 are used for detecting accessories that are not shown, the capacitive sensors 2 are used for detecting the presence of a portion of a living being in the proximity of the sensor. Other sensors such as gravimetric or radio sensors (not shown) could also be installed on the doll 1.

Each capacitive sensor 2 can lead to a different action depending on its location in the body of the doll 1. By means of this system, malfunction due to the presence of metal objects are avoided.

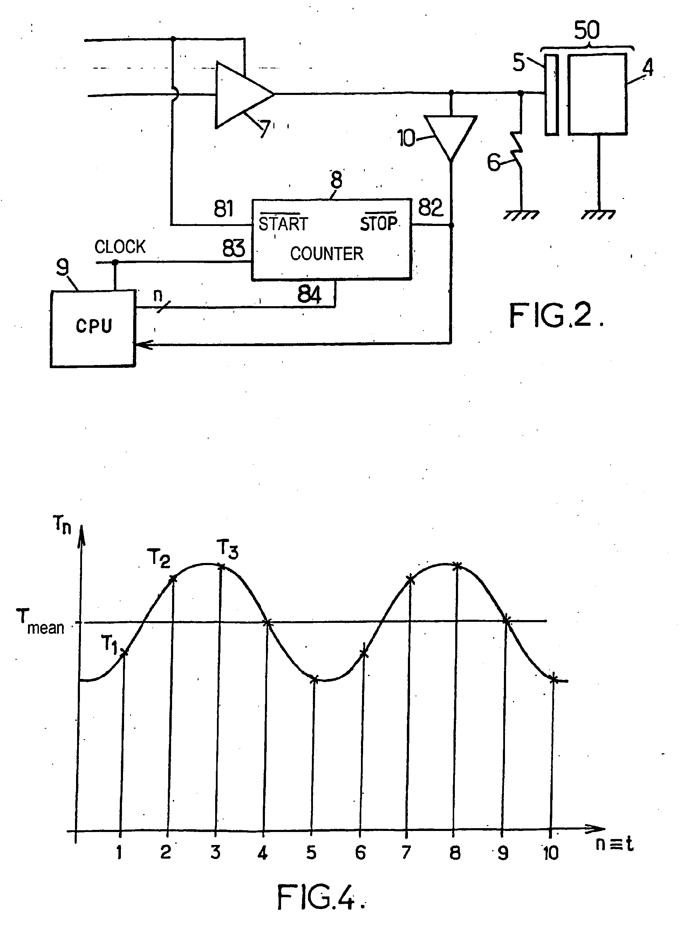

The operation of the capacitive sensors 2 is shown in Figure 2. A capacitive sensor 2 is constituted by a detection plate 5 and a resistor 6 connected between the detection plate 5 and ground. On the approach of a portion of a human being 4, the capacitor 50 formed by the detection plate 5 and the portion of the human being 4 changes so that the discharge time of the RC circuit formed by the resistor 6 and the capacitor 50 is changed. An amplifier 7 serves to recharge the capacitor 50 so that a counter 8 measures the discharge time of the RC circuit. The counter 8 co-operates with the amplifier 7 by means of a start-count signal 81. Thus, when the capacitor 50 has been charged by the amplifier 7, the start-count signal 81 informs the counter 8 that it should start counting. Similarly, a stop-count signal 82 serves to stop the counter 8 and to inform a central processor unit (CPU) 9 that it can read the data delivered by the counter 8 on a data bus 84. The counter 8 and the CPU 9 are synchronized by means of a common clock signal 83.

Consequently, in order to start charging the capacitor 50 constituted by the detection plate 5 and the portion of the living being 4, the CPU 9 instructs the amplifier 7 to start charging by putting the signal 81 in the one state. The amplifier 7 then delivers electrical power to the detection plate 5 until it is charged. When the capacitor 50 constituted by the detection plate 5 and the portion of the living being 4 has finished being charged, the signal 81 changes to zero, thus stopping the amplifier 7 and starting the counter 8. Once the capacitor 50 constituted by the detection plate 5 and the portion of the living being 4 has been discharged, a Schmidt comparator 10 puts the stop-counting signal 82 to zero, thus stopping the counter 8 and informing the CPU 9 that it should store the discharge time value present on the bus 84.

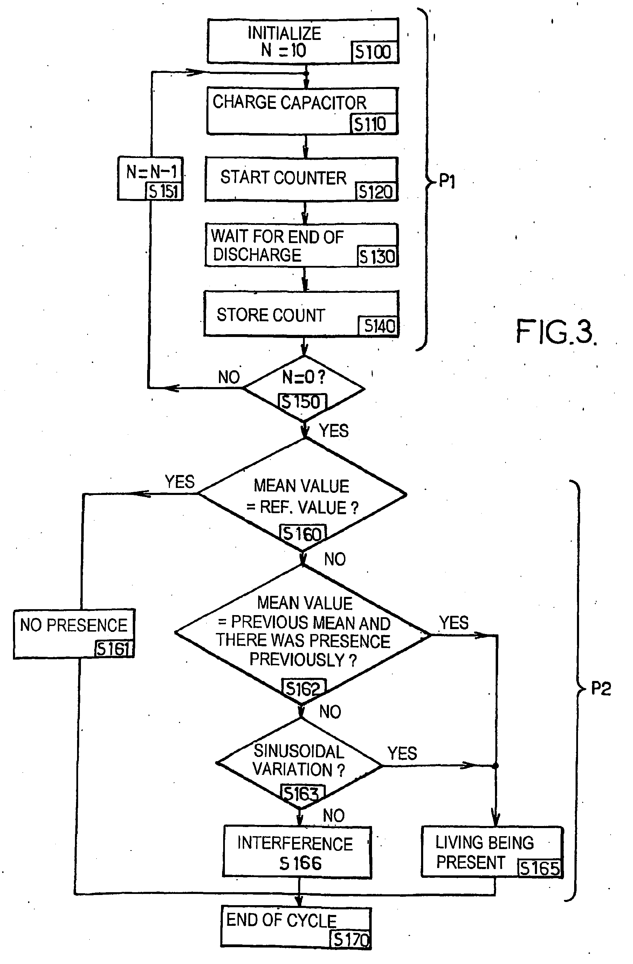

By repeating this operation a certain number of times, a collection of discharge time values stored in a memory (not shown in the figure) by the CPU 9 is built up, and on the basis of this collection analysis described below makes it possible to determine whether a living being is indeed in the proximity of the doll 1. This system presents the advantage of being simple and easy to implement. It can then co-operate with the CPU 9 in such a manner as to implement the method shown by the flow chart of Figure 3.

In addition, the detection plate 5 acts as an antenna for receiving the radio waves transmitted by the nearby portion of a living being. This has the effect of causing the time required for the capacitor 50 to discharge to vary over time, with this variation presenting the form of a sinusoidal signal having the same frequency as the frequency of the electrical power distribution network.

In Figure 3, a flow chart shows how the detection method in accordance with the invention runs. The method takes place in two distinct stages P1 and P2, P1 being the sampling stage during which a collection of discharge time values for the capacitor 50 is built up using the circuits shown in Figure 2, and stage P2 being the analysis stage during which the data collected during the stage P1 is analyzed.

The stage P1 begins with initializing the system (S100). During this step (S100), the value of N is initialized to 10. This value determines the number of discharge times that go to making up a single collection.

As explained above when describing Figure 2, the capacitor 50 is charged during the next step (S110). Once the capacitor 50 is charged, the counter 8 is started in the next step (S120). The capacitor 50 discharges at this time. The detector 10 serves to detect the end of capacitor discharging in the next step (S130).

Once the capacitor 50 is fully discharged, the stop-count signal is activated and the CPU stores the value presented by the counter 8 in the next step (S140). A test serves to determine the value of N (S150). If the value of N is not zero, then N is decremented in a step (S151) and another charge cycle is begun: the method returns to step (S110). When the value of N is zero in test step (S150), then the stage P1 has terminated and a collection of ten values has been built up in the memory of the CPU 9.

The stage P2 serves to analyze the data collected during the stage P1. Initially, the mean value of the collection is compared with a reference value. If the mean value is substantially equal to the reference value, then it can be concluded that there is no portion of a living being in the proximity of the detector 5 (S161). Otherwise, if the mean value of the collection is not substantially equal to the reference value, then said current mean value of the collection is compared with the mean value of a preceding collection (S162). If these two mean values are substantially identical and if during the preceding cycle it was concluded that a portion of a living being was in the proximity of the detector of the invention, then it can again be concluded that said portion continues to be in the proximity of the detector. Otherwise, if the mean collection values are not identical, or if it was not decided previously that a portion of a living being was in the proximity of the detector, then the process continues to the next step (S163).

During step S163, variations in the values of discharge time around the mean value of the collection are compared with a sinusoidal signal of frequency substantially equal to the frequency of the electrical power distribution network. Figure 4 is a graph showing the discharge times T1 to T10 of a single collection. These discharge-times T1 to T10 vary about a collection mean value Tmean. During step S163, the CPU 9 looks for a sinusoidal waveform at a frequency substantially equal to the frequency of the electrical power distribution network in the variations in the values T1 to T10 of the discharge time. If, as is the case in Figure 4, it is possible to superpose such a sinusoidal signal on the discharge time values T1 to T10, then it is concluded that a portion of a living being is present in the proximity of the detector. Otherwise, it is concluded that there is interference from a metal object (S166). The method then terminates with a conclusion step (S170) which causes effects to be activated if it has been conclude that a portion of a living being is present in the proximity of the detector.

In an embodiment, the reference value of step (S161) is readjusted as a function of external conditions such as the temperature, the pressure, or indeed the humidity of the surrounding air.

## Claims

1. A toy including at least one capacitive sensor (2) comprising a metal plate (5) constituting one of the two plates of a capacitor (50), the second plate being constituted by a portion of a living being (4) in the proximity of the toy,
at least one effects generator; and
a control circuit including means for causing effects to take place in response to stimulation of said capacitive sensor (2);
the toy being **characterized in that** said metal plate (5) of said at least one capacitive sensor (2) is used as an antenna for picking up radio frequency transmission from said portion of a living being (4) in the proximity of the toy.

2. The toy according to claim 1, in which the radio frequency transmission is at the frequency of an electrical power distribution network.

3. The toy according to claim 1 or claim 2, including means for charging and discharging the capacitor (50) of said at least one capacitive sensor (2).

4. The toy according to claim 3, including a counter (8) for measuring the discharge time of said at least one capacitive sensor (2).

5. The toy according to claim 4, including means (81) for starting the counter (8) when the capacitor (50) is charged, and means (82) for stopping the counter (8) when the capacitor (50) is discharged.

6. The toy according to claim 5, including a control circuit (9) connected to the counter (8) and having means for storing a plurality of discharge times issued by the counter (8), said plurality of discharge times constituting a collection.

7. The toy according to claim 6, in which the control circuit (9) includes means for analyzing the collection of a plurality of discharge times, and means for detecting variation in the mean value of the collection relative to the mean value of the preceding collection.

8. The toy according to claim 6 or claim 7, in which the control circuit (9) includes means for comparing variation in the values of the discharge times within a single collection with a sinusoidal signal of frequency substantially equal to the frequency of an electrical power distribution network.

9. The toy according to any preceding claim in which a resistor (6) is located between ground and the base of the first plate (5) of the capacitor (50) of said at least one capacitive sensor (2), the resistor (6) and the capacitor (50) thus constituting an RC circuit.

10. The toy according to any preceding claim, including a variable frequency radio frequency generator generating an electromagnetic field,
at least one accessory including a passive resonant circuit constituted by an inductor connected in series with a capacitor and responsive to an electromagnetic field at a determined frequency; and
means (3) for determining the presence of at least one accessory and for stimulating the effects generator in such a manner as to cause it to produce an effect.

11. The toy according to any preceding claim, **characterized in that** it is a doll (1) having a plurality of capacitive sensors (2) situated at various locations of the doll (1).

12. A method of detecting human presence for a toy according to any preceding claim, said method comprising at least the steps consisting in:
· making a collection comprising a plurality of values for the discharge time of the capacitor (50);
· comparing the mean value of the collection with a reference discharge time value (50);
· comparing the mean value of the collection with the mean value of the preceding collection; and **characterised by**
· comparing any variations between the discharge time values of the capacitor (50) within the collection with a sinusoidal signal of frequency substantially equal to the frequency of an electrical power distribution network nearby said portion of a living being.

13. The method according to claim 12, in which it is concluded that a portion of a living being (4) is present when the variations in the discharge time values present substantially the form of said sinusoidal signal.

14. The method according to claim 12 or claim 13, in which it is concluded that a portion of a living being (4) is present if the mean value of the current collection is substantially equal to the mean value of the preceding collection, and if it was previously concluded that a portion of a living being (4) was present.

15. The method according to any one of claims 12 to 14, in which it is concluded that no portion of a living being (4) is present when the mean value of the current collection is substantially equal to a reference value.

16. The method according to claim 15, in which the reference value is a function of external conditions.

17. The method according to any one of claims 12 to 16, in which the collection comprises ten discharge time values.

## Patentansprüche

1. Spielzeug mit mindestens einem kapazitiven Näherungssensor (2), umfassend
eine Metallplatte (5), die eine der beiden Platten eines Kondensators (50) bildet, wobei die zweite Platte von einem Teil eines Lebewesens (4) in der Nähe des Spielzeugs gebildet wird,
mindestens einen Effektgenerator; und
eine Steuerschaltung mit Mitteln zum Verursachen von Effekten, die als Reaktion auf die Anregung des kapazitiven Näherungssensors (2) stattfinden;
wobei das Spielzeug **dadurch gekennzeichnet ist, dass** die Metallplatte (5) des mindestens einen Näherungssensors (2) als Antenne zum Auffangen einer Funkfrequenzübertragung von dem Teil eines Lebewesens (4) in der Nähe des Spielzeugs verwendet wird.

2. Spielzeug nach Anspruch 1, in dem die Funkfrequenzübertragung die Frequenz eines Stromverteilungsnetzes ist.

3. Spielzeug nach Anspruch 1 oder Anspruch 2, mit Mitteln zum Laden und Entladen des Kondensators (50) des mindestens einen kapazitiven Näherungssensors (2).

4. Spielzeug nach Anspruch 3, mit einem Zäher (8) zum Messen der Entladedauer des mindestens einen kapazitiven Näherungssensors (2).

5. Spielzeug nach Anspruch 4, mit Mitteln (81) zum Starten des Zählers (8), wenn der Kondensator (50) geladen ist, und Mitteln (82) zum Stoppen des Zählers (8), wenn der Kondensator (50) entladen ist.

6. Spielzeug nach Anspruch 5, mit einer mit dem Zähler (8) verbundenen Steuerschaltung (9) und mit Mitteln zum Speichern einer von dem Zähler (8) ausgegebenen Vielzahl von Entladedauern, wobei diese Vielzahl von Entladedauern eine Sammlung bildet.

7. Spielzeug nach Anspruch 6, in dem die Steuerschaltung (9) Mittel zum Analysieren der Sammlung einer Vielzahl von Entladedauern sowie Mittel zum Erfassen einer Veränderung des Mittelwertes der Sammlung bezogen auf den Mittelwert der vorhergehenden Sammlung umfasst.

8. Spielzeug nach Anspruch 6 oder Anspruch 7, in dem die Steuerschaltung (9) Mittel zum Vergleichen einer Veränderung der Werte der Entladedauern innerhalb einer einzigen Sammlung mit einem sinusförmigen Signal einer Frequenz, die im Wesentlichen gleich der Frequenz eines Stromverteilungsnetzes ist, umfasst.

9. Spielzeug nach einem der vorhergehenden Ansprüche, in dem ein Widerstand (6) zwischen Masse und der Basis der ersten Platte (5) des Kondensators (50) des mindestens einen kapazitiven Näherungssensors (2) angeordnet ist und der Widerstand (6) und der Kondensator (50) somit eine Widerstands-Kapazitäts-Schaltung bilden.

10. Spielzeug nach einem der vorhergehenden Ansprüche, mit einem Funkfrequenzgenerator variabler Frequenz zum Erzeugen eines elektromagnetischen Feldes,
mindestens einem Zubehörteil mit einem passiven Resonanzkreis, der von einer mit einem Kondensator in Serie geschalteten Induktivität gebildet ist und auf ein elektromagnetisches Feld einer bestimmten Frequenz anspricht; und
Mittel (3) zum Bestimmen des Vorliegens mindestens eines Zubehörteils und zum Anregen des Effektgenerators derart, dass er einen Effekt erzeugt.

11. Spielzeug nach einem der vorhergehenden Ansprüche,
**dadurch gekennzeichnet, dass**
dieses eine Puppe (1) ist, mit einer Vielzahl kapazitiver Näherungssensoren (2), die an unterschiedlichen Stellen der Puppe (1) angeordnet sind.

12. Verfahren zum Erfassen der Gegenwart eines Menschen für ein Spielzeug nach einem der vorhergehenden Ansprüche, wobei das Verfahren mindestens die folgenden Schritte umfasst:
- Bilden einer Sammlung umfassend eine Vielzahl von Werten für die Entladedauer des Kondensators (50);
- Vergleichen des Mittelwertes der Sammlung mit einem Referenzwert der Entladedauer (50);
- Vergleichen des Mittelwertes der Sammlung mit dem Mittelwert der vorhergehenden Sammlung;
und **gekennzeichnet durch**
- Vergleichen von Veränderungen zwischen den Entladedauerwerten des Kondensators (50) innerhalb der Sammlung mit einem sinusförmigen Signal einer Frequenz, die im Wesentlichen gleich der Frequenz eines Stromverteilungsnetzes ist, das sich in der Nähe des Teils eines Lebewesens befindet.

13. Verfahren nach Anspruch 12, in dem die Gegenwart eines Teils eines Lebewesens (4) gefolgert wird, wenn die Veränderungen in den Entladedauerwerten im Wesentlichen die Form des sinusförmigen Signals darstellen.

14. Verfahren nach Anspruch 12 oder Anspruch 13, in dem die Gegenwart eines Teils eines Lebewesens (4) gefolgert wird, wenn der Mittelwert der Stromsammlung im Wesentlichen gleich dem Mittelwert der vorhergehenden Sammlung ist, und wenn zuvor gefolgert wurde, dass ein Teil eines Lebewesens (4) anwesend war.

15. Verfahren nach einem der Ansprüche 12 bis 14, in dem die Abwesenheit eines Teils eines Lebewesens (4) gefolgert wird, wenn der Mittelwert der Stromsammlung im Wesentlichen gleich einem Referenzwert ist.

16. Verfahren nach Anspruch 15, in dem der Referenzwert eine Funktion externer Bedingungen ist.

17. Verfahren nach einem der Ansprüche 12 bis 16, in dem die Sammlung zehn Entladedauerwerte umfasst.

## Revendications

1. Jouet comportant au moins un capteur capacitif (2) comprenant une plaque métallique (5) constituant une des deux armatures d'une capacité (50), la deuxième armature étant constituée par une partie d'un être vivant (4) à proximité du jouet,
au moins un générateur d'effets, et
un circuit de commande comportant des moyens pour commander des effets en réponse à la stimulation dudit capteur capacitif (2),
le jouet étant **caractérisé en ce que** ladite plaque métallique (5) dudit au moins un capteur capacitif (2) est utilisée comme antenne pour capter une émission radiofréquence transmise par ladite partie d'un être vivant (4) à proximité du jouet.

2. Jouet selon la revendication 1, dans lequel l'émission radiofréquence est à la fréquence d'un réseau de distribution d'énergie électrique.

3. Jouet selon la revendication 1 ou 2, comprenant des moyens pour charger et décharger la capacité (50) dudit au moins un capteur capacitif (2).

4. Jouet selon la revendication 3, comprenant un compteur (8) pour mesurer le temps de décharge dudit au moins un capteur capacitif (2).

5. Jouet selon la revendication 4, comprenant des moyens (81) pour lancer le compteur (8) lorsque la capacité (50) est chargée et des moyens (82) pour arrêter le compteur (8) lorsque la capacité (50) est déchargée.

6. Jouet selon la revendication 5, comprenant un circuit de commande (9) relié au compteur (8) et qui comprend des moyens pour mémoriser une pluralité de temps de décharge transmise par le compteur (8), ladite pluralité de temps de décharge constituant une collection.

7. Jouet selon la revendication 6, dans lequel le circuit de commande (9) comprend des moyens pour analyser la collection de la pluralité de temps de décharge, et des moyens pour détecter une variation de la valeur moyenne de la collection par rapport à la valeur moyenne de la collection précédente.

8. Jouet selon la revendication 6 ou 7, dans lequel le circuit de commande (9) comprend des moyens pour comparer les variations des valeurs de temps de décharge au sein d'une même collection avec un signal sinusoïdal de fréquence sensiblement égale à la fréquence d'un réseau de distribution d'énergie électrique.

9. Jouet selon l'une quelconque des revendications précédentes, dans lequel une résistance (6) se trouve entre la base de la première armature (5) de la capacité (50) dudit au moins un capteur capacitif (2) et la masse, la résistance (6) et la capacité (50) constituant ainsi un circuit RC.

10. Jouet selon l'une quelconque des revendications précédentes, comprenant un générateur radiofréquence à fréquence variable, générant un champ électromagnétique, au moins un accessoire comportant un circuit résonant passif constitué de la mise en série d'une inductance et d'une capacité, répondant à un champ électromagnétique d'une fréquence déterminée, des moyens (3) pour détecter la présence dudit au moins un accessoire et stimuler le générateur d'effets de telle sorte qu'il produise un effet.

11. Jouet selon l'une quelconque des revendications précédentes, **caractérisé en ce qu'**il est une poupée (1), comprenant plusieurs capteurs capacitifs (2) situés à divers endroits sur la poupée (1).

12. Procédé de détection de présence humaine pour un jouet selon l'une quelconque des revendications précédentes, ledit procédé comprenant au moins les étapes consistant à :
- constituer une collection comprenant une pluralité de valeurs de temps de décharge de la capacité (50),
- comparer la valeur moyenne de la collection à une valeur de référence du temps de décharge (50),
- comparer la valeur moyenne de la collection à la valeur moyenne de la collection précédente,
et **caractérisé en ce qu'**il comporte une étape visant à
- comparer toute variation entre des valeurs de temps de décharge de la capacité (50) au sein de la collection et un signal sinusoïdal dont la fréquence est sensiblement égale à la fréquence du réseau de distribution électrique à proximité de ladite partie d'une être vivant.

13. Procédé selon la revendication 12, dans lequel on conclut à la présence d'une partie d'un être vivant (4), lorsque les variations des valeurs de temps de décharge ont sensiblement la forme dudit signal sinusoïdal.

14. Procédé selon la revendication 12 ou 13, dans lequel on conclut à la présence d'une partie d'un être vivant (4), si la valeur moyenne de la collection courante est sensiblement égale à la valeur moyenne de la collection précédente et si on avait conclu précédemment à une présence d'une partie d'un être vivant (4).

15. Procédé selon l'une quelconque des revendications 12 à 14, dans lequel on conclut à une absence de partie d'être vivant (4), lorsque la valeur moyenne de la collection courante est sensiblement égale à une valeur de référence.

16. Procédé selon la revendication 15, dans lequel la valeur de référence est une fonction de conditions extérieures.

17. Procédé selon l'une quelconque des revendications 12 à 16, dans lequel la collection comprend dix valeurs de temps de décharges.
